# EUROPEAN PATENT APPLICATION

(11) **EP 1 710 626 A1**
(43) Date of publication of application: **11.10.2006**
(21) Application number: 05703982.8
(22) Date of filing: 21.01.2005
(51) Int. Cl.: G03F 7/027

(54) **PHOTOSENSITIVE RESIN COMPOSITION AND CURED PRODUCT THEREOF**

(30) Priority: 26.01.2004 JP 2004016751
(71) Applicant: NIPPON KAYAKU KABUSHIKI KAISHA, Tokyo 102-8172 (JP)
(72) Inventor: KOYANAGI, Hiroo, Tokyo 1750092 (JP); TANAKA, Ryutaro, Tokyo 1150042 (JP); KAMETANI, Hideaki, Tokyo 1150042 (JP)
(74) Representative: Gille Hrabal Struck Neidlein Prop Roos
(86) International application number: PCT/JP2005/000761
(87) International publication number: WO 2005/071489

(57) **Abstract**

[PROBLEMS]

To provide a photosensitive resin composition with excellent photosensitivity whose cured product is excellent in adhesiveness, pencil hardness, solvent resistance, acid resistance, heat resistance, gold plating resistance, HAST properties, flame retardance, flexibility and the like a cured product thereof.

[MEANS FOR SOLVING PROBLEMS]

A photosensitive resin composition comprising a carboxyl group-containing resin (A) which is a reaction product of a compound (a) represented by the following formula (1): 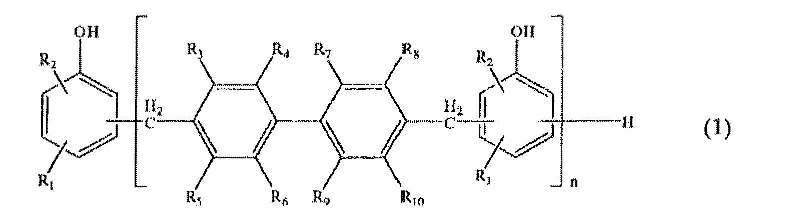 wherein n is an average value of 1 to 20; R₁ and R₂ may be the same or different, and are each a hydrogen atom, a halogen atom or a C₁ to C₄ lower alkyl group; R₃, R₅, R₈ and R₁₀ may be the same or different, and are each a hydrogen atom, a halogen atom or a methyl group; and R₄, R₆, R₇ and R₉ may be the same or different, and are each a hydrogen atom or a methyl group, a compound (b) having an ethylenically unsaturated group and a glycidyl group in the molecule and a polybasic acid anhydride (c), a crosslinking agent (B) and a photopolymerization initiator (C), and a cured product thereof.

## Description

### Technical Field

The present invention relates to a photosensitive resin composition which can be used for a solder mask, an electroless gold plating resist and the like in manufacturing printed wiring boards and which can be developed by an organic solvent or aqueous alkaline solution, and a cured product thereof. More specifically, the present invention relates to a cured product of a photosensitive resin composition high in flexibility and excellent in adhesiveness, pencil hardness, solvent resistance, acid resistance, heat resistance, gold plating resistance, HAST (Highly Accelerated Temperature and Humidity Stress Test) properties, flame retardance and the like.

### Background Art

The solder mask is used for avoiding adhesiveness of solder to positions other than objective ones on soldering components to printed wire circuit boards and protecting circuits on printed wire circuit boards, and is an ink requiring characteristics such as electric insulation, heat resistance, adhesiveness and chemical resistance. Initially, melamine-based heat-curable solder resist inks were used, but afterward, epoxy-based heat-curable solder resist inks came to be developed which are excellent in heat resistance, hardness, adhesiveness, chemical resistance and the like, and have become the mainstream in printed wire circuit boards for industrial devices related to computers, etc., which place importance on a high reliability.

On the other hand, since solder resist inks used for consumer printed wire circuit boards require workability and productivity, ultraviolet-curable solder resist inks which are obtained by acrylating epoxy resins and further acid-modifying and which can be developed by an aqueous alkaline solution have become the mainstream in place of epoxy-based heat-curable solder resist inks. Because of the miniaturization, high functionalization, resource saving, cost reduction, etc., of recent electronics devices, the requirement for the precision improvement in circuit pattern densities has become high also in industrial printed wire circuit boards, and photographically developable solder masks are being developed. As examples thereof, compositions comprising resins obtained by reacting a phenol novolac epoxy acrylate resin or a cresol epoxy acrylate resin with a polybasic acid anhydride, are mainly industrially used. Further, in order to improve heat resistance, proposed compositions comprising resins obtained by reacting partially phenolic hydroxy groups with glycidyl (meth)acrylate and modifying with polybasic acid anhydrides are described in Patent Document 1, Patent Document 2 and Patent Document 3. These compositions are used in a method in which they are coated on a printed wiring board, and after a heat treatment (soft baking treatment), exposed to ultraviolet rays with a mask pattern closely contacted, and thereafter developed by a suitable aqueous alkaline solution to remove ultraviolet unirradiated parts to patternize.

For improving flexibility, Patent Document 4 proposes that an unsaturated group-containing compound having the biphenyl skeleton is used together with a (meth)acrylate compound other than this skeleton; and Patent Document 5 proposes a resin composition which can be developed by an organic solvent or aqueous alkaline solution and which is obtained by reacting an epoxy compound having the biphenyl skeleton with an unsaturated group-containing monocarboxylic acid compound and adding an acid anhydride for the purpose of providing plating resistance, heat resistance and solvent resistance.
Patent Document 1: Japanese Patent Application Laying Open (KOKAI) No. 2002-308957
Patent Document 2: Japanese Patent Application Laying Open (KOKAI) No. 2002-138125
Patent Document 3: Japanese Patent Application Laying Open (KOKAI) No. 2002-128865
Patent Document 4: Japanese Patent Application Laying Open (KOKAI) No. 2003-82067
Patent Document 5: Japanese Patent Application Laying Open (KOKAI) No. 11-140144

### Disclosure of the Invention

### Problems to be Solved by the Invention

However, almost all of novolac epoxy resins used in the compositions described in Patent Document 1, Patent Document 2 and Patent Document 3 do not conventionally have flexibility, and when they are applied to printed wiring boards of thin film type used in recent portable devices, they have troubles such as generating cracks in cured products. The cured product of the resin composition described in Patent Document 4 uses a (meth)acrylate compound other than the biphenyl skeleton in combination, but cannot meet the requirement for the reliability including HAST and the flame retardance, which are needed at present. Further, the epoxy (meth)acrylate resin used in the resin composition described in Patent Document 5 has a problem with curability of the composition.

In order to miniaturize, reduce the weight of and improve the communication speed of portable devices, printed wiring boards are required to have a higher precision and higher density, and accordingly requirements for solder masks are more and more severe. The printed wiring boards are now required to have higher flexibility and more excellent adhesiveness, pencil hardness, solvent resistance, acid resistance, heat resistance, gold plating resistance, HAST properties, flame retardance and the like than in conventional ones. However, now commercially available solder masks cannot fully meet the requirements described above.

An object of the present invention is to provide a photosensitive resin composition which is excellent in photosensitivity to active energy rays and capable of patterning fine images that can meet the high functionalization of present printed wiring boards with the development by aqueous alkaline and which satisfies characteristics of obtained cured films demanded for solder masks, and provide a cured product thereof.

### Means for Solving the Problems

For solving the problems described before, the present inventors have extensively studied to obtain a photosensitive resin composition which is excellent in photosensitivity and whose cured product is excellent in flexibility, adhesiveness, pencil hardness, solvent resistance, acid resistance, heat resistance, gold plating resistance, HAST properties, flame retardance and the like, and the cured product, and then achieved the present invention.

That is, the present invention is to provide:
(1) a photosensitive resin composition comprising a carboxyl group-containing resin (A) which is a reaction product of a compound (a) represented by the following formula (1): 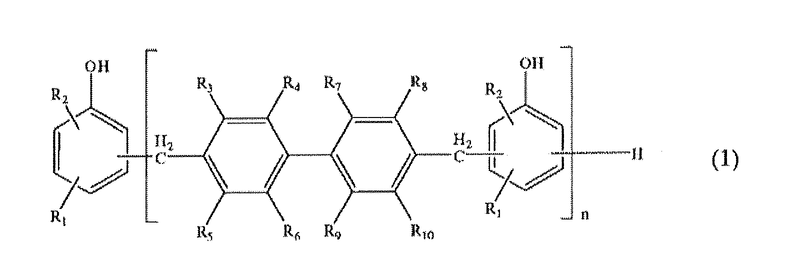 wherein n is an average value of 1 to 20; R₁ and R₂ may be the same or different, and are each a hydrogen atom, a halogen atom or a C₁ to C₄ lower alkyl group; R₃, R₅, R₈ and R₁₀ may be the same or different, and are each a hydrogen atom, a halogen atom or a methyl group; and R₄, R₆, R₇ and R₉ may be the same or different, and are each a hydrogen atom or a methyl group, a compound (b) having an ethylenically unsaturated group and a glycidyl group in the molecule and a polybasic acid anhydride (c), a crosslinking agent (B), and a photopolymerization initiator (C);
(2) a photosensitive resin composition described in (1) further comprising a reaction product (A') of a compound (a) represented by the formula (1) and a compound (b) having an ethylenically unsaturated group and a glycidyl group in the molecule;
(3) a photosensitive resin composition described in (1) or (2) wherein all of R₁ to R₁₀ of the compound (a) of the formula (1) are a hydrogen atom;
(4) a photosensitive resin composition described in any one of (1) to (3) wherein a compound (b) having an ethylenically unsaturated group and a glycidyl group is one or more kinds selected from the group consisting of glycidyl (meth)acrylate, a glycidyl ether of 3-hydroxypropyl (meth)acrylate, a glycidyl ether of 4-hydroxybutyl (meth)acrylate, a glycidyl ether of pentaerythritol triacrylate, a glycidyl ester of maleimidocaproic acid and a glycidyl ether of cinnamic acid;
(5) a cured product of the photosensitive resin composition described in any one of (1) to (4);
(6) a base material having a layer of the cured product described in (5); and
(7) an article having the base material described in (6).

### Advantages of the Invention

Since the photosensitive resin composition of the present invention is excellent in tackiness and photosensitivity, and can be patterned by development by an aqueous alkaline solution, and its cured product is high in flexibility and together has performances excellent in adhesiveness, solder heat resistance, electroless gold plating resistance and the like, the composition is suitable for inter layer dielectrics for electronic components, photo-waveguides to connect optical components, resist materials for solder masks and cover-lays for printed wiring boards, and the like.

### Best Mode for Carrying Out the Invention

The photosensitive resin composition of the present invention is characterized by preferably comprising a carboxyl group-containing acrylate resin (A) having the biphenyl skeleton, a crosslinking agent (B) and a photopolymerization initiator (C).

The carboxyl group-containing acrylate resin (A) having the biphenyl skeleton usable in the present invention is obtained by reacting a compound (a) represented by the above-mentioned formula (1), a compound (b) having an ethylenically unsaturated group and a glycidyl group in the molecule and a polybasic acid anhydride (c).

In the above-mentioned formula (1), R₁ and R₂ may be the same or different, and are each a hydrogen atom, a halogen atom or a C₁ to C₄ lower alkyl group; R₃, R₅, R₈ and R₁₀ may be the same or different, and are each a hydrogen atom, a halogen atom or a methyl group; R₄, R₆, R₇ and R₉ may be the same or different, and are each a hydrogen atom or a methyl group; and n is an average value of 1 to 20.

In the above-mentioned formula (1), the C₁ to C₄ lower alkyl group includes, for example, a methyl group, ethyl group, n-propyl group, isopropyl group, n-butyl group, isobutyl group and t-butyl group; and the halogen atom includes, for example, a fluorine atom, chlorine atom, bromine atom and iodine atom. The compound (a) represented by the above-mentioned formula (1) is commonly used as a mixture of compounds having different polymerization degrees, and n is an average value of 1 to 20, preferably of 1.1 to 10, more preferably of 1.2 to 5. Here, n can be calculated from the epoxy equivalent of the compound of the formula (1).

The compound (a) represented by the above-mentioned formula (1) usable for the carboxyl group-containing acrylate resin (A) having the biphenyl skeleton includes a compound obtained by dehydration-condensing a 4,4'-dimethylolbiphenyl derivative compound and a phenol derivative compound with an acidic catalyst such as oxalic acid, sulfuric acid or hydrochloric acid, and a compound obtained by dehalogeno acid-condensing a 4,4'-dihalogenomethylbiphenyl derivative compound and a phenol derivative compound by heating.

The 4,4'-dimethylolbiphenyl derivative compound includes, for example, 4,4'-dimethylolbiphenyl, 4,4'-dimethylol-3,3',5,5'-tetramethylbiphenyl, 4,4'-dimethylol-3,3',5,5'-tetrachlorobiphenyl, 4,4'-dimethylol-3,3',5,5'-tetrabromobiphenyl and 4,4'-dimethylol-2,2'-dimethylbiphenyl.

The 4,4'-dihalogenomethylbiphenyl derivative compound includes, for example, 4,4'-dichloromethylbiphenyl, 4,4'-dichloromethyl-3,3',5,5'-tetramethylbiphenyl and 4,4'- dibromomethylbiphenyl.

The phenol derivative compound includes, for example, phenol, o-cresol, m-cresol, p-cresol, 2,6-dimethylphenol, 2,4-dimethylphenol, 2-ethylphenol, 2-propylphenol, 2-chlorophenol, 2-bromophenol and 2,4-dichlorophenol.

In the above-mentioned formula (1), a favorable combination of R₁ to R₁₀ includes, for example, a compound in which all of R₁ to R₁₀ is a hydrogen atom. A compound (a) represented by the above-mentioned formula (1) includes, for example, commercially available products, MEH-7851 SS (n=1.5), MEH-7851M (n=2.1) and MEH-7851-3H (n=3.2) (all manufactured by Meiwa Plastic Industries, Ltd.).

The compound (b) having an ethylenically unsaturated group and a glycidyl group in the molecule usable for the carboxyl group-containing acrylate resin (A) having a biphenyl skeleton of the present invention includes, for example, glycidyl (meth)acrylate, a glycidyl ether of 3-hydroxypropyl (meth)acrylate, a glycidyl ether of 4-hydroxybutyl (meth)acrylate, a glycidyl ether of pentaerythritol triacrylate, a glycidyl ester of maleimidocaproic acid and a glycidyl ester of cinnamic acid. It includes especially preferably glycidyl (meth)acrylate and a glycidyl ether of 4-hydroxybutyl (meth)acrylate, and as commercially available products, glycidyl methacrylate (manufactured by Wako Pure Chemical Ind., Ltd.) and 4-hydroxybutyl acrylate glycidyl ether (manufactured by Nippon Kasei Chemical Co., Ltd.).

As the polybasic acid anhydride (c), any of them can be used as long as it is a compound having the acid anhydride structure in the molecule. It is preferably an acid anhydride of a dibasic acid or a tribasic acid, which is excellent in the aqueous alkaline solution developability, heat resistance, hydrolysis resistance and the like, such as succinic acid anhydride, phthalic acid anhydride, tetrahydrophthalic acid anhydride, hexahydrophthalic acid anhydride, itaconic acid anhydride, 3-methyl-tetrahydrophthalic acid anhydride, 4-methyl-hexahydrophthalic acid anhydride, trimellitic acid anhydride and maleic acid anhydride, and especially preferably among them, succinic acid anhydride and tetrahydrophthalic acid anhydride.

The carboxyl group-containing acrylate resin (A) having the biphenyl skeleton can be obtained by a reaction of a compound (a) of the formula (1), a compound (b) having an ethylenically unsaturated group and a glycidyl group in the molecule and a polybasic acid anhydride (c). The compound (a) and the compound (b) are made to react solventlessly or in an organic solvent, or in a single or mixed organic solvent of a crosslinking agent (B) described later, etc., in an epoxy equivalent of the compound (b) of 0.5 to 1.0 per hydroxyl equivalent of the compound (a).

The organic solvent includes, for example, ketones such as acetone, ethyl methyl ketone and cyclohexanone, aromatic hydrocarbons such as benzene, toluene, xylene and tetramethylbenzene, glycol ethers such as ethylene glycol dimethyl ether, ethylene glycol diethyl ether, propylene glycol monomethyl ether, dipropylene glycol dimethyl ether, dipropylene glycol monomethyl ether, dipropylene glycol diethyl ether, triethylene glycol dimethyl ether and triethylene glycol diethyl ether, esters such as ethyl acetate, butyl acetate, methyl cellosolve acetate, ethyl cellosolve acetate, butyl cellosolve acetate, carbitol acetate, propylene glycol monomethyl ether acetate, diethylene glycol monoethyl ether acetate, a dialkyl glutarate, a dialkyl succinate and a dialkyl adipate, cyclic esters such as γ-butyrolactone, and petroleum solvents such as a petroleum ether, petroleum naphtha, hydrogenated petroleum naphtha and solvent naphtha.

At the time of the reaction of the compound (a) and the compound (b), addition of a thermal polymerization inhibitor is preferable to suppress the thermal polymerization reaction. The amount of the heat polymerization inhibitor used is preferably 0.05 to 10 wt% to the compound (a), more preferably 0.1 to 5 wt%. The usable thermal polymerization inhibitor includes hydroquinone, 2-methylhydroquinone, hydroquinone monomethyl ether and 2,6-di-tert-butyl-p-cresol.

At the time of the reaction of the compound (a) and the compound (b), use of a catalyst is preferable to promote the reaction. The use amount of the catalyst is preferably 0.1 to 10 wt% to the compound (a), more preferably 0.2 to 5 wt%. The reaction temperature at the time is preferably 60 to 150°C, more preferably 80 to 130°C. The reaction time is preferably 3 to 60 h, further preferably 5 to 40 h. The catalyst usable for the reaction includes, for example, dimethylaminopyridines such as 4-dimethylaminopyridine, triethylamine, benzyldimethylamine, triethylammonium chloride, benzyltrimethylammonium bromide, benzyltrimethylammonium iodide, triphenylphosphine, triphenylstibine, methyltriphenylstibine, chromium 2-ethylhexanoate, chromium octanoate, zinc 2-ethylhexanoate, zinc octanoate, zirconium octanoate, dimethylsulfide, and diphenylsulfide.

The reaction to add the polybasic acid anhydride (c) can be performed by adding a polybasic acid anhydride (c) to the reaction solution after the reaction of the compound (a) and the compound (b). The reaction temperature at the time is preferably 60 to 150°C, and the reaction time is preferably 2 to 8 h. The adding amount of the polybasic acid anhydride (c) is preferably charged in such a calculated amount from the viewpoint of developability that the acid value of the solid content of the carboxyl group-containing acrylate resin (A) having the biphenyl skeleton finally obtained is 40 to 160 mg·KOH/g.

The photosensitive resin composition of the present invention may further contain a reaction product (A') of a compound (a) represented by the above-mentioned formula (1) and a compound (b) having an ethylenically unsaturated group and a glycidyl group in the molecule. That is, the present invention involves a photosensitive resin composition containing a carboxyl group-containing acrylate resin (A), a reaction product (A'), a crosslinking agent (B) and a photopolymerization initiator (C). The manufacturing method of the reaction product (A') of the compound (a) and the compound (b) is as described above.

The crosslinking agent (B) used for the photosensitive resin composition of the present invention includes a (meth)acrylic acid derivative, for example, 2-hydroxyethyl (meth)acrylate, 2-hydroxypropyl (meth)acrylate, 1,4-butanediol mono(meth)acrylate, carbitol (meth)acrylate, acryloyl morpholine, a half ester which is a reaction product of a hydroxyl-containing (meth)acrylate and an acid anhydride of a polybasic acid compound, polyethylene glycol di(meth)acrylate, tripropylene glycol di(meth)acrylate, trimethylolpropane tri(meth)acrylate, trimethylolpropane polyethoxy tri(meth)acrylate, glycerin polypropoxy tri(meth)acrylate, a di(meth)acrylate of ε-caprolactone addition of neopentyl glycol hydroxypivalte (e.g., KAYARAD HX-220, HX-620, etc., manufactured by Nippon Kayaku Co., Ltd.), pentaerythritol tetra(meth)acrylate, a poly(meth)acrylate of a reaction product of dipentaerythritol and ε-caprolactone (e.g., an ε-caprolactone-modified dipentaerythritol hexaacrylate (DPCA-60), etc., manufactured by Nippon Kayaku Co., Ltd.), dipentaerythritol poly(meth)acrylate and an epoxy (meth)acrylate which is a reaction product of mono- or poly-glycidyl compound and (meth)acrylate. The crosslinking agent (B) can be used alone or as a mixture of two or more kinds thereof.

The hydroxy-containing (meth)acrylate as the crosslinking agent (B) in a half ester which is a reaction product of the hydroxy-containing (meth)acrylate and an acid anhydride of a polybasic acid compound includes, for example, 2-hydroxyethyl (meth)acrylate, 2-hydroxypropyl (meth)acrylate and 1,4-butanediol mono(meth)acrylate. The acid anhydride of the polybasic acid compound includes, for example, succinic acid anhydride, maleic acid anhydride, phthalic acid anhydride, tetrahydrophthalic acid anhydride and hexahydrophthalic acid anhydride.

The mono- or poly-glycidyl compound as the crosslinking agent (B) in an epoxy (meth)acrylate which is a reaction product of a mono- or poly-glycidyl compound and (meth)acrylic acid includes, for example, butyl glycidyl ether, phenyl glycidyl ether, polyethylene glycol diglycidyl ether, polypropylene glycol diglycidyl ether, 1,6-hexanediol diglycidyl ether, diglycidyl hexahydrophthalate, glycerin polyglycidyl ether, glycerin polyethoxy glycidyl ether, trimethylolpropane polyglycidyl ether and trimethylolpropane polyethoxy polyglycidyl ether.

The photopolymerization initiator (C) usable for the photosensitive resin composition of the present invention includes, for example, benzoins such as benzoin, benzoin methyl ether, benzoin ethyl ether, benzoin propyl ether and benzoin isobutyl ether, acetophenones such as acetophenone, 2,2-diethoxy-2-phenylacetophenone, 2,2-diethoxy-2-phenylacetophenone, 1,1-dichloroacetophenone, 2-hydroxy-2-methyl-phenylpropane-1-one, diethoxyacetophenone, 1-hydroxycyclohexyl phenyl ketone and 2-methyl-1-[4-(methylthio)phenyl]-2-morpholino-propane-1-one, anthraquinones such as 2-ethylanthraquinone, 2-tert-butylanthraquinone, 2-chloroanthraquinone and 2-amylanthraquinone, thioxanthones such as 2,4-diethylthioxanthone, 2-isopropylthioxanthone and 2-chlorothioxanthone, ketals such as acetophenone dimethyl ketal and benzyl methyl ketal, benzophenones such as benzophenone, 4-benzoyl-4'-methyldiphenyl sulfide and 4,4'-bismethylaminobenzophenone, and phosphine oxides such as 2,4,6-trimethylbenzoyldiphenylphosphine oxide and bis(2,4,6-trimethylbenzoyl)-phenylphosphine oxide.

The photopolymerization initiator (C) can be used alone or as a mixture of two or more kinds, and further in combination with a promoter and the like including a tertiary amine such as triethanolamine or methyldiethanolamine, and a benzoic acid derivative such as ethyl N,N-dimethylaminobenzoate or isoamyl N,N-dimethylaminobenzoate.

A curing component can optionally be added to the photosensitive resin composition of the present invention for the purpose of further improving heat resistance, etc. The curing component includes, for example, an epoxy compound and an oxazine compound. The curing component is preferably used especially in the case where it reacts by heating with carboxyl groups and hydroxyl groups residual in the resin coating film after photopolymerization for obtaining a cured coating film having a further strong chemical resistance.

The epoxy compound as the curing component includes, for example, a phenol novolac epoxy resin, cresol novolac epoxy resin, trishydroxyphenylmethane epoxy resin, dicyclopentadiene phenol epoxy resin, bisphenol-A epoxy resin, bisphenol-F epoxy resin, biphenol epoxy resin, bisphenol-A novolac epoxy resin, naphthalene skeleton-containing epoxy resin and heterocyclic epoxy resin.

The phenol novolac epoxy resin includes, for example, Epiclon N-770 (manufactured by Dainippon Ink and Chemicals, Inc.), D.E.N438 (manufactured by Dow Chemical Co.), Epikote 154 (manufactured by Japan Epoxy Resins Co., Ltd.) and RE-306 (manufactured by Nippon Kayaku Co., Ltd.). The cresol novolac epoxy resin includes, for example, Epiclon N-695 (manufactured by Dainippon Ink and Chemicals, Inc.), EOCN-102S, EOCN-103S, EOCN-104S (all manufactured by Nippon Kayaku Co., Ltd.), UVR-6650 (manufacture by Union Carbide Corp.) and ESCN-195 (manufactured by Sumitomo Chemical Co., Ltd.).

The trishydroxyphenylmethane epoxy resin includes, for example, EPPN-503, EPPN-502H, EPPN-501H (all manufactured by Nippon Kayaku Co., Ltd.), TACTIX-742 (manufactured by Dow Chemical Co.) and Epikote E1032H60 (manufactured by Japan Epoxy Resins Co., Ltd.). The dicyclopentadienephenol epoxy resin includes, for example, Epiclon EXA-7200 (manufactured by Dainippon Ink and Chemicals, Inc.) and TACTIX-556 (manufactured by Dow Chemical Co.).

The bisphenol-A epoxy resin includes, for example, Epikote 828, Epikote 1001 (all manufactured by Japan Epoxy Resins Co., Ltd.), UVR-6410 (manufacture by Union Carbide Corp.), D.E.R-331 (manufactured by Dow Chemical Co.) and YD-8125 (manufactured by Tohto Kasei Co., Ltd.). The bisphenol-F epoxy resin includes, for example, UVR-6490 (manufacture by Union Carbide Corp.) and YDF-8170 (manufactured by Tohto Kasei Co., Ltd.).

The biphenol epoxy resin includes, for example, a biphenol epoxy resin such as NC-3000, NC-3000H (all manufactured by Nippon Kayaku Co., Ltd.), a bixylenol epoxy resin of YX-4000 (manufactured by Japan Epoxy Resins Co., Ltd.), and YL-6121 (manufactured by Japan Epoxy Resins Co., Ltd.). The bisphenol-A novolac epoxy resin includes, for example, Epiclon N-880 (manufactured by Dainippon Ink and Chemicals, Inc.) and Epikote E157S75 (manufactured by Japan Epoxy Resins Co., Ltd.).

The naphthalene skeleton-containing epoxy resin includes, for example, NC-7000, NC-7300 (all manufactured by Nippon Kayaku Co., Ltd.) and EXA-4750 (manufactured by Dainippon Ink and Chemicals, Inc.). The cyclic epoxy resin includes, for example, EHPE-3150 (manufactured by Daicel Chemical Industries, Ltd.). The heterocyclic epoxy resin includes, for example, TEPIC-L, TEPIC-H, TEPIC-S (all manufactured by Nissan Chemical Industries, Ltd.).

The oxazine compound as the curing component includes, for example, B-m type benzoxazine, P-a type benzoxazine, B-a type benzoxazine (all manufactured by Shikoku Chemicals Corp.).

The photosensitive resin composition of the present invention can be obtained preferably by mixing a carboxyl group-containing acrylate resin (A) having a biphenyl skeleton, a crosslinking agent (B), a photopolymerization initiator (C) and an optional curing component. The photosensitive resin composition of the present invention contains, based on 100 wt% of a nonvolatile content of the photosensitive resin composition of the present invention, preferably 10 to 80 wt% of the component (A), 3 to 60 wt% of the component (B) and 0.5 to 30 wt% of the component (C), more preferably 20 to 70 wt% of the component (A), 5 to 30 wt% of the component (B) and 2 to 20 wt% of the component (C). The optional curing component is preferably 0 to 50 wt%. In the case of the resin composition further containing (A'), the total of components (A) and (A') is preferably 10 to 80 wt%.

Further optionally, various kinds of additives, for example, thermosetting catalysts such as melamine, fillers such as talc, barium sulfate, calcium carbonate, magnesium carbonate, barium titanate, aluminum hydroxide, aluminum oxide, silica and clay, tixotropy-imparting agents such as aerosil, colorants such as phthalocyanine blue, phthalocyanine green, titanium oxide and green pigment, leveling agents and defoaming agents such as a silicone and fluorine-based one, polymerization inhibitors such as hydroquinone and hydroquinone monomethyl ether, and the like, can be added for improving characteristics of the photosensitive resin composition.

When a curing component described before is added, it may previously be mixed in the above-mentioned photosensitive resin composition, or may be mixed before coating to a base material such as a printed wiring board. Namely, it is formulated into a two-pack type consisting of a base solution in which an epoxy curing promoter and the like are blended with the above-mentioned component (A) as a main component, and a curing component solution containing a curing component as a main component, and they are mixed and used at the use time.

The above-mentioned photosensitive resin composition is kneaded and can be melted by heating as the case may be, and if kneaded preferably by a three-roll mill, is improved in dispersibility and characteristics including resolution and heat resistance. Especially when the above-mentioned various additives are used, the kneading method using a three-roll mill is more preferable. The same is said of the case of the two-pack type of the above-mentioned base solution and curing component solution.

The photosensitive resin composition of the present invention can also be used as a solder mask of dry-film type having a structure in which the resin composition is sandwiched between a supporting film and a protective film.

The photosensitive resin composition (liquid or film) of the present invention is useful as inter layer dielectrics of electronic components, photo-waveguides to connect optical components, resist materials for solder masks, cover-lays and the like for printed wiring boards, and can be used as color filters, printing inks, sealing compounds, paints, coating agents, adhesives and the like.

The cured product of the photosensitive resin composition of the present invention indicates one which is obtained by curing the photosensitive resin composition of the present invention by the energy ray irradiation such as ultraviolet rays, and curing can be performed by the common procedure of the energy ray irradiation such as ultraviolet rays. For example, when ultraviolet rays are irradiated, an ultraviolet generator such as a low pressure mercury lamp, high pressure mercury lamp, extra-high pressure mercury lamp, xenon lamp or ultraviolet emission laser (excimer laser, etc.) can be used.

The base material having a layer of the cured product of the present invention indicates one that has a layered cured product which is obtained by curing the photosensitive resin composition of the present invention by the energy ray irradiation such as ultraviolet rays, and includes electric, electronic and optical components such as printed wiring boards, optoelectronic boards and optical boards as resist films, inter layer dielectrics for the buildup process and photo-waveguides. Articles having these base materials include, for example, automobiles, airplanes, computers, household electric appliances and portable devices. The thickness of the cured product layer is preferably about 0.5 to 160 µm, more preferably about 1 to 100 µm.

Taking a printed wiring board as an example, a base material having the cured product layer of the present invention can be obtained, for example, as follows. That is, when a liquid resin composition is used, a photosensitive resin composition of the present invention is coated in a thickness of 5 to 160 µm on a board for printed wiring by the bar coating method, screen printing method, spray method, roll coating method, electrostatic coating method, curtain coating method and the like; and the coated film is dried commonly at a temperature of 50 to 110°C, preferably at 60 to 100°C, commonly for 10 to 90 min, preferably for 30 to 60 min, thereby forming a coating film. Thereafter, the coating film is irradiated directly or indirectly with high energy rays such as ultraviolet rays in an intensity of commonly about 10 to 2,000 mJ/cm², preferably 300 to 1,000 mJ/cm² through a photo mask in which an exposure pattern such as a negative film is formed; and the unexposed part is developed using a developer described later, for example, by spray, rocking immersion, brushing, and scrubbing. Thereafter, it is optionally further irradiated with ultraviolet rays, and then heat-treated commonly at a temperature of 100 to 200°C, preferably at 140 to 180°C, commonly for 0.5 to 5 h, preferably for 0.8 to 3 h, thereby obtaining a printed wiring board having a permanent protective film excellent in gold plating processability and satisfying characteristics such as heat resistance, solvent resistance, acid resistance and adhesiveness.

As an above-mentioned developer usable for developing, an organic solvent or an aqueous alkaline solution can be used. The usable organic solvent includes, for example, ketones such as acetone, ethyl methyl ketone and cyclohexanone, aromatic hydrocarbons such as benzene, toluene, xylene and tetramethylbenzene, glycol ethers such as ethylene glycol dimethyl ether, ethylene glycol diethyl ether, dipropylene glycol dimethyl ether, dipropylene glycol diethyl ether, triethylene glycol dimethyl ether and triethylene glycol diethyl ether, esters such as ethyl acetate, butyl acetate, methyl cellosolve acetate, ethyl cellosolve acetate, butyl cellosolve acetate, carbitol acetate, propylene glycol monomethyl ether acetate, a dialkyl glutarate, a dialkyl succinate and a dialkyl adipate, cyclic esters such as γ-butyrolactone, and petroleum solvents such as a petroleum ether, petroleum naphtha, hydrogenated petroleum naphtha and solvent naphtha.

The usable aqueous alkaline solution includes, for example, inorganic aqueous alkaline solutions such as potassium hydroxide, sodium hydroxide, sodium carbonate, potassium carbonate, sodium hydrogencarbonate, potassium hydrogencarbonate, sodium phosphate and potassium phosphate, and organic aqueous alkaline solution such as tetramethylammonium hydroxide, tetraethylammonium hydroxide, tetrabutylammonium hydroxide, monoethanolamine, diethanolamine and triethanolamine. The concentration of the aqueous alkaline solution in the case of its use is commonly 0.1 to 5 wt%, preferably 0.5 to 3 wt%.

### Examples

Hereinafter, the present invention will be further explained by way of examples, but the scope of the present invention is not limited to the following

### examples.

### Synthetic Example 1

In a flask of 1 L with a stirring device and a reflux tube, 150 g of diethylene glycol monoethyl ether acetate as the reaction solvent, 200 g (one equivalent) of MEH-7851SS (trade name; manufactured by Meiwa Plastic Industries, Ltd.; and in the formula (1), R₁ to R₁₀ are each a hydrogen atom, n=1.5, and a hydroxy group equivalent of 20 g/equivalent) as the compound (a), 150 g (0.75 equivalent) of 4-hydroxybutylacrylate glycidyl ether (manufactured by Nippon Kasei Chemical Co., Ltd.; an epoxy equivalent of 200 g/equivalent) as the compound (b), 1 g of 4-dimethylaminopyridine as the reaction catalyst and 1 g of 2,6-di-tert-butyl-p-cresol as the thermal polymerization inhibitor were charged, and made to react at a temperature of 120°C for 24 h till the epoxy group in the reactant solution had been extinguished, thereby obtaining a resin solution containing 70 wt% of an acrylate resin having the biphenyl skeleton. This resin solution was denoted by (A'-1). The acid value of the resin solution (A'-1) was 0.2 mg·KOH/g (0.3 mg·KOH/g in terms of solid content).

### Synthetic Example 2

In a flask of 1 L with a stirring device and a reflux tube, 150 g of diethylene glycol monoethyl ether acetate as the reaction solvent, 200 g (one equivalent) of MEH-7851-3H (trade name; manufactured by Meiwa Plastic Industries, Ltd.; and in the formula (1), R₁ to R₁₀ are each a hydrogen atom, n=3.2, and a hydroxy group equivalent of 200 g/equivalent) as the compound (a), 150 g (0.75 equivalent) of 4-hydroxybutylacrylate glycidyl ether (manufactured by Nippon Kasei Chemical Co., Ltd.; an epoxy equivalent of 200 g/equivalent) as the compound (b), 1 g of 4-dimethylaminopyridine as the reaction catalyst and 1 g of 2,6-di-tert-butyl-p-cresol as the thermal polymerization inhibitor were charged, and made to react at a temperature of 120°C for 24 h till the epoxy group in the reactant solution had been extinguished, thereby obtaining a resin solution containing 70 wt% of an acrylate resin having the biphenyl skeleton. This resin solution was denoted by (A'-2). The acid value of the resin solution (A'-2) was 0.8 mg·KOH/g (1.1 mg·KOH/g in terms of solid content).

### Synthetic Example 3

In the resin solution (A'-2) obtained in Synthetic Example 2, 114 g (0.75 equivalent) of tetrahydrophthalic acid anhydride as the polybasic acid anhydride (c) and 49 g of diethylene glycol monoethyl ether acetate as the solvent were charged, and made to react at a temperature of 100°C for 6 h to obtain a resin solution (A-3) containing 70 wt% of a carboxyl group-containing acrylate resin (A) having the biphenyl skeleton. The acid value of the resin solution (A-3) was 63.4 mg·KOH/g (90.6 mg·KOH/g in terms of solid content).

### Synthetic Example 4

In the resin solution (A'-2) obtained in Synthetic Example 2, 75 g (0.75 equivalent) of succinic acid anhydride as the polybasic acid anhydride (c) and 32 g of diethylene glycol monoethyl ether acetate as the solvent were charged, and made to react at a temperature of 100°C for 6 h to obtain a resin solution (A-4) containing 70 wt% of a carboxyl group-containing acrylate resin (A) having the biphenyl skeleton. The acid value of the resin solution (A-4) was 69.3 mg·KOH/g (99 mg·KOH/g in terms of solid content).

### Examples 1 to 3

The resin solutions (A'-1), (A-3) and (A-4) obtained in the above-mentioned Synthetic Example 1, Synthetic Example 3 and Synthetic Example 4 and other components were mixed in the formulation ratio shown in Table 1, and optionally kneaded by a three-roll mill to obtain a photosensitive resin composition of the present invention. This was coated in a thickness of 15 to 25 µm on a printed copper circuit board by the bar coating method, and the coated film was dried in a hot air drier of 80°C for 60 min. The obtained coating film was confirmed for tackiness as described later. Then, a mask film in which a pattern was drawn was closely contacted, which was irradiated with ultraviolet rays using an ultraviolet aligner (500W Multilight, manufactured by USHIO Inc.). Then, it was spray-developed (spray pressure: 0.2 MPa) for 120 sec using a 2 wt% sodium carbonate aqueous solution (temperature: 30°C) which was the alkaline developer. After rinsing, the resultant was heat-treated for 60 min in a hot air drier of 150°C to obtain a cured product of the present invention. The obtained cured product was tested for photosensitivity, surface glossiness, adhesiveness, pencil hardness, solvent resistance, acid resistance, heat resistance, gold plating resistance, HAST properties and flexibility. These results are shown in Table 2. The test methods and evaluation methods are as follows.

(Tackiness) The tackiness of a coating film was evaluated by scrubbing by an absorbent cotton the coating film coated on a printed wiring board and cooled to room temperature after dried.
G ... The absorbent cotton does not stick
B ... The absorbent cotton lint sticks to the film
(Photosensitivity) Whether or not a cured product was obtained by developing a coating film after the coating film after dried was irradiated with ultraviolet rays, was confirmed. The following standard was applied.
G ... Cured even at an irradiance of not more than 150 mJ/cm²
F ... Cured at an irradiance of 150 to 500 mJ/cm²
B ... Not cured unless the irradiance was not less than 500 mJ/cm²

(Surface glossiness) A cured film was obtained by the above-mentioned method after the coating film after dried was irradiated with ultraviolet rays of 500 mJ/cm². The obtained cured film was immersed in ethanol for 60 sec, and the cured film after dried was observed. The following standard was applied.
G ... No blur observed at all
F ... A little blur observed
B ... Blur observed, no glossiness

(Adhesiveness) A cured film was obtained by the above-mentioned method after the coating film after dried was irradiated with ultraviolet rays of 500 mJ/cm². According to JIS K5400, one hundred cross-cuts of each 1 mm were cut in a test piece of the obtained cured film, and the peeling test was conducted using Cellotape®. The peeling state of the cross-cuts was observed, and evaluated on the following standard.
G ... Not peeled
B ... Peeled

(Pencil hardness) A cured film was obtained by the above-mentioned method after the coating film after dried was irradiated with ultraviolet rays of 500 mJ/cm². The obtained cured film was evaluated according to JIS K5400.

(Solvent resistance) A cured film was obtained by the above-mentioned method after the coating film after dried was irradiated with ultraviolet rays of 500 mJ/cm². The obtained cured film was immersed in isopropyl alcohol at room temperature for 30 min, and then, whether or not it had an abnormal appearance was confirmed.
G ... No blur observed at all
B ... A little blur observed

(Acid resistance) A cured film was obtained by the above-mentioned method after the coating film after dried was irradiated with ultraviolet rays of 500 mJ/cm². The obtained cured film was immersed in a 10 wt% hydrochloric acid aqueous solution at room temperature for 30 min. Whether or not it had an abnormal appearance was confirmed, and then, the peeling test using Cellotape® was conducted, and evaluated on the following standard.
G ... No abnormal film appearance, no swelling, no exfoliation
B ... Swelling or exfoliation on the film

(Heat resistance) A cured film was obtained by the above-mentioned method after the coating film after dried was irradiated with ultraviolet rays of 500 mJ/cm². The obtained cured film was coated with a rosin-based flux, and immersed in a solder bath of 260°C for 5 sec. With this denoting one cycle, this was repeated three cycles. It was cooled to room temperature, and the peeling test using Cellotape® was then conducted, and evaluated on the following standard.
G ... No abnormal film appearance, no swelling, no exfoliation
B ... Swelling or exfoliation on the film

(Gold plating resistance) A cured film was obtained by the above-mentioned method after the coating film after dried was irradiated with ultraviolet rays of 500 mJ/cm². The obtained cured film was immersed in an acidic degreasing solution (a 20 vol% aqueous solution of Metex L-5B, manufactured by Japan MacDermid Co., Ltd.) of 30°C for 3 min, and thereafter washed with water, and then, immersed in a 14.4 wt% ammonium persulfate aqueous solution at room temperature for 3 min. Thereafter, the test board was washed with water, and further immersed in a 10 vol% sulfuric acid aqueous solution at room temperature for 1 min, and then washed with water. Next, the board was immersed in a catalyst solution (a 10 vol% aqueous solution of Metal Plate Activator 350, manufactured by Meltex Inc.) of 30°C for 7 min, washed with water, immersed in a nickel plating solution (a 20 vol% aqueous solution of Melplate Ni-865M, pH 4.6, manufactured by Meltex Inc.) of 85°C for 20 min to plate nickel, and thereafter immersed in a 10 vol% sulfuric acid aqueous solution at room temperature for 1 min, and washed with water. Then, the test board was immersed in a gold plating solution (an aqueous solution of 15 vol% of Aurolectroless UP and 3 vol% of potassium cyanoaurate, pH 6, manufactured by Meltex Inc.) of 95°C for 10 min to perform the electroless gold plating, thereafter washed with water, further immersed in hot water of 60°C for 3 min, washed with water, and dried. A cellophane adhesive tape was adhered to the obtained electroless gold-plated evaluation board, and states of exfoliation were observed.
G ... No abnormality at all
B ... A little exfoliation observed

(HAST properties) A cured film was obtained by the above-mentioned method after the coating film after dried was irradiated with ultraviolet rays of 500 mJ/cm². The obtained cured film was allowed to stand in a pressurized steam of a temperature of 121 °C and a humidity of 85% for 200 h. A cellophane adhesive tape was adhered to the obtained evaluation board, and states of exfoliation were observed.
G ... No abnormality at all
B ... A little exfoliation observed

(Flexibility) A cured film was obtained by the above-mentioned method after the coating film after dried was irradiated with ultraviolet rays of 500 mJ/cm². The obtained cured film was bent completely through 180°, and states of bent parts were observed.
G ... No abnormality at all
B ... Having fine cracks

**Table 1**

| | Example | | | |
|---|---|---|---|---|
| | | 1 | 2 | 3 |
| Resin | | | | |
| A'-1 | | | | 20.00 |
| A-3 | | 34.26 | | |
| A-4 | | | 34.26 | 31.05 |

| Crosslinking agent (B) | | | | |
|---|---|---|---|---|
| DPCA-60 | (*1) | 6.00 | 6.00 | 8.93 |

| Photopolymerization initiator (C) | | | | |
|---|---|---|---|---|
| Irg907 | (*2) | 4.94 | 4.94 | 7.36 |
| DETX-S | (*3) | 0.50 | 0.50 | 0.75 |

| Curing component | | | | |
|---|---|---|---|---|
| Epikote 828 | (*4) | 7.19 | 7.19 | |
| NC-3000 | (*5) | 14.39 | 14.39 | |

| Additive | | | | |
|---|---|---|---|---|
| Melamine | | 1.44 | 1.44 | |
| B-31 | (*6) | 10.02 | 10.02 | 14.94 |
| Green pigment | | 0.38 | 0.38 | 0.57 |
| BYK-354 | (*7) | 0.58 | 0.58 | 0.86 |
| KS-66 | (*8) | 0.58 | 0.58 | 0.86 |

| Solvent for adjusting concentration | | | | |
|---|---|---|---|---|
| CA | (*9) | 10.72 | 10.72 | 14.69 |
| DPM | (*10) | 6.00 | 9.00 | |
| PM | (*11) | 3.00 | | |

| | | | | |
|---|---|---|---|---|
| Note *1 ε-caprolactone-modified dipentaerythritol hexaacrylate (manufactured by Nippon Kayaku Co., Ltd.) *2 2-methyl-1-[4-(methylthio)phenyl]-2-morpholino-propan-1-one (manufactured by Ciba Specialty Chemicals Corp.) *3 2,4-diethylthioxanthone (manufactured by Nippon Kayaku Co., Ltd.) *4 Bisphenol-A epoxy resin (manufactured by Japan Epoxy Resins Co., Ltd.) *5 Biphenyl epoxy resin (manufactured by Nippon Kayaku Co., Ltd.) *6 Barium sulfate (manufactured by Sakai Chemical Industry Co., Ltd.) *7 Leveling agent (manufactured by BYK-Chemie GmbH) *8 Defoaming agent (manufactured by Shin-Etsu Chemical Co., Ltd.) *9 Diethylene glycol monoethyl ether acetate *10 Dipropylene glycol monomethyl ether *11 Propylene glycol monomethyl ether | | | | |

**Table 2**

| | Example | | |
|---|---|---|---|
| | 1 | 2 | 3 |
| Evaluation item | | | |
| Tackiness | G | G | G |
| Photosensitivity | G | G | G |
| Surface glossiness | G | G | G |
| Adhesiveness | G | G | G |
| Pencil hardness | 4H | 4H | 5H |
| Solvent resistance | G | G | G |
| Acid resistance | G | G | G |
| Heat resistance | G | G | G |
| Gold plating resistance | G | G | G |
| HAST properties | G | G | G |
| Flexibility | G | G | G |

### Example 4

The photosensitive resin composition of the present invention used in Example 1 was coated (dried film thickness of 50 µm) on a polyethylene terephthalate film, and dried in a drier of 80°C for 30 min. This film was irradiated with ultraviolet rays of 500 mJ/cm², and the obtained cured film was peeled off the film board. The obtained cured film was cured by heating at 150°C for 60 min, and cut into a width of 5 mm by a cutter. When the strip-shaped cured film was ignited and observed for the burning susceptibility, the flame was immediately extinguished, and thus the cured film was observed to have the flame retardance.

As is clear from Examples, since the photosensitive resin composition of the present invention is highly sensitive, and its cured film is high in flexibility and excellent in adhesiveness, pencil hardness, solvent resistance, acid resistance, heat resistance, gold plating resistance, HAST properties, flame retardance and the like, the composition is suitable especially as a photosensitive resin composition for flexible printed wiring boards.

### Industrial Applicability

The photosensitive resin composition of the present invention is excellent in photosensitivity in the formation of a coating film by curing through ultraviolet ray exposure, and the obtained cured product is high in flexibility and fully satisfies adhesiveness, pencil hardness, solvent resistance, acid resistance, heat resistance, gold plating resistance, HAST properties, flame retardance and the like, and can suitably be used for photo-curing coatings, photo-curing adhesives and the like, especially as a photosensitive resin composition for printed wiring boards.

## Claims

1. A photosensitive resin composition comprising a carboxyl group-containing resin (A) which is a reaction product of a compound (a) represented by the following formula (1): 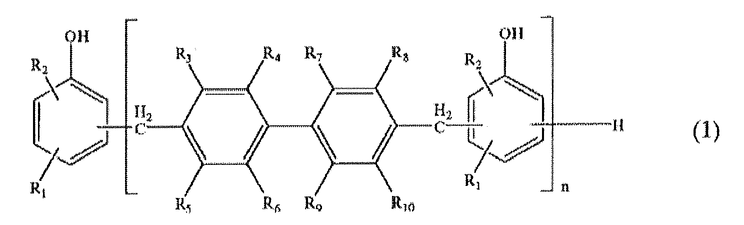 wherein n is an average value of 1 to 20; R₁ and R₂ may be the same or different, and are each a hydrogen atom, a halogen atom or a C₁ to C₄ lower alkyl group; R₃, R₅, R₈ and R₁₀ may be the same or different, and are each a hydrogen atom, a halogen atom or a methyl group; and R₄, R₆, R₇ and R₉ may be the same or different, and are each a hydrogen atom or a methyl group, a compound (b) having an ethylenically unsaturated group and a glycidyl group in the molecule and a polybasic acid anhydride (c), a crosslinking agent (B) and a photopolymerization initiator (C).

2. The photosensitive resin composition according to claim 1, further comprising a reaction product (A') of a compound (a) represented by the formula (1) and a compound (b) having an ethylenically unsaturated group and a glycidyl group in the molecule.

3. The photosensitive resin composition according to claim 1 or 2, wherein all of R₁ to R₁₀ of the compound (a) of the formula (1) are a hydrogen atom.

4. The photosensitive resin composition according to any one of claims 1 to 3, wherein the compound (b) having an ethylenically unsaturated group and a glycidyl group in the molecule is one or more kinds selected from the group consisting of glycidyl (meth)acrylate, a glycidyl ether of 3-hydroxypropyl (meth)acrylate, a glycidyl ether of 4-hydroxybutyl (meth)acrylate, a glycidyl ether of pentaerythritol triacrylate, a glycidyl ester of maleimidocaproic acid and a glycidyl ester of cinnamic acid.

5. A cured product of the photosensitive resin composition according to any one of claims 1 to 4.

6. A base material having a layer of the cured product according to claim 5.

7. An article having the base material according to claim 6.
